# EUROPEAN PATENT APPLICATION

(11) **EP 2 637 281 A2**
(43) Date of publication of application: **11.09.2013**
(21) Application number: 12161912.6
(22) Date of filing: 28.03.2012
(51) Int. Cl.: H02J 7/00, G01R 31/36

(54) **Charge indicator circuit**

(30) Priority: 07.03.2012 CN 201210058064
(71) Applicant: Hong Fu Jin Precision Industry (ShenZhen) Co., Ltd., Longhua Town, Bao'an District Shenzhen City Guangdong 518109 (CN); Hon Hai Precision Industry Co., Ltd., New Taipei City (TW)
(72) Inventor: Cheng, Hai-Long, Shenzhen City, Guangdong Province (CN); Wang, Tao, Shenzhen City, Guangdong Province (CN); Deng, Xue-Bing, Shenzhen City, Guangdong Province (CN); Ma, Xiao-Hui, Shenzhen City, Guangdong Province (CN); Li, Xin-Ping, Shenzhen City, Guangdong Province (CN); Shi, Yong-Song, Shenzhen City, Guangdong Province (CN)
(74) Representative: Gray, John James

(57) **Abstract**

An exemplary charge indicator circuit indicates the state of charge of a battery. The charge indicator circuit includes a connection jack (10), an indicator module (30), a voltage detection module, a charger IC (60), and a path connection module (40). The indicator module includes an indicator (301). The indicator is on when the battery (70) is being charged. The voltage detection module is to output a first response signal when the connection jack is connected to the power supply (50). The charger IC is to manage the charging of the battery, and output a low level signal when a condition of the battery is satisfied. The path connection module is in a shunt circuit of the indicator module, and enables the shunt circuit of the indicator module to cause the indicator to be on when the voltage detection module outputs the first response signal and the charger IC outputs the low level signal.

## Description

### BackGround

### Technical Field

The present disclosure relates to circuits and, more particularly, to a charge indicator circuit.

### Description of Related Art

A charge indicator circuit is to control the indicator to be on or to be off through a software control method, such as through a controller, thus the charge indicator circuit of related art is complicated. Moreover, when the controller is power off, the controller will be disabled and cannot control the indicator to be on or to be off.

It is desirable to provide a new charge indicator circuit to resolve the above problems.

### BRIEF DESCRIPTION OF THE DRAWINGS

The components in the drawings are not necessarily drawn to scale, the emphasis instead being placed upon clearly illustrating the principles of the charge indicator circuit. Moreover, in the drawings, like reference numerals designate corresponding parts throughout the several views.

FIG. 1 is a block diagram of a charge indicator circuit in accordance with an exemplary embodiment.

FIG. 2 is a circuit diagram of the charge indicator circuit of FIG. 1.

### DETAILED DESCRIPTION

The disclosure is illustrated by way of example and not by way of limitation in the figures of the accompanying drawings in which like references indicate similar elements. It should be noted that references to "an" or "one" embodiment in this disclosure are not necessarily to the same embodiment, and such references mean at least one.

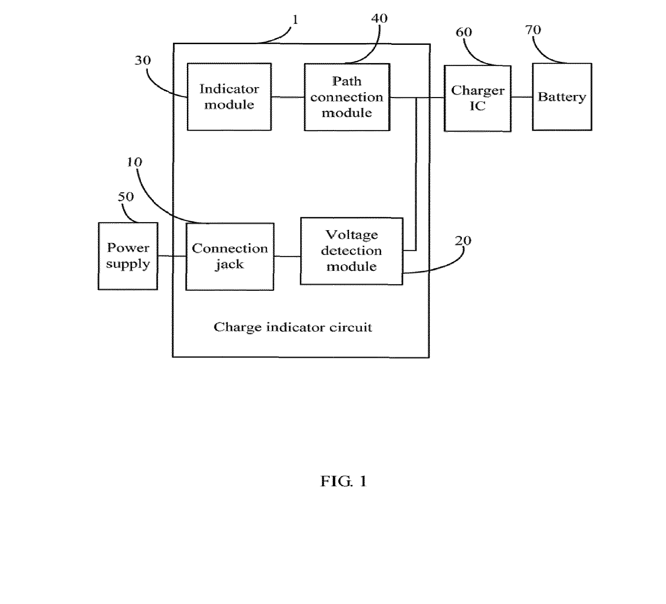

Referring to FIG. 1, a block diagram of a charge indicator circuit 1 is shown. The circuit 1 includes a connection jack 10, a voltage detection module 20, an indicator module 30, and a path connection module 40. The connection jack 10 is connected to a power supply 50 to receive power from the power supply 50. The path connection module 40 is connected to a charger IC 60 and is in a shunt circuit of the indicator module 30 to enable or disable the shunt circuit of the indicator module 30.

The charger IC 60 is to manage the charging of a battery 70. When a condition of the battery 70 is satisfied, for example, such as the battery 70 is not fully charged, the charger IC 60 outputs a low level signal. When the condition of the battery 70 is not satisfied, for example, such as the battery 70 is fully charged, the charger IC 60 outputs a high level signal.

The voltage detection module 20 is to output a first response signal when the connection jack 10 is connected to the power supply 50, the path connection module 40 enables the shunt circuit of the indicator module 30 when the voltage detection module 20 outputs the first response signal and the charger IC 60 outputs the low level signal. The voltage detection module 20 is further to output a second response signal when the connection jack 10 is not connected to the power supply 50, the path connection module 40 disables the shunt circuit of the indicator module 30 when the voltage detection module 20 outputs the second response signal or the charger IC 60 outputs the high level signal.

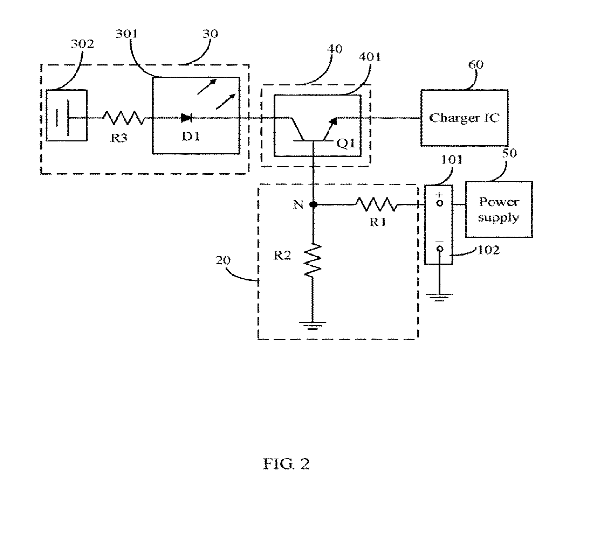

Referring to FIG. 2, a circuit diagram of the charge indicator circuit 1 is shown. The connection jack 10 includes an anode input port 101 and a cathode input port 102 respectively connected to an anode and a cathode of the power supply 50. The voltage detection module 20 includes a first resistor R1 and a second resistor R2. The first resistor R1 and the second resistor R2 are connected in series between the anode input port 101 and ground. The node N formed between the first resistor R1 and the second resistor R2 is connected to the path connection module 40. When the connection jack 10 is connected to the power supply 50, the voltage of the power supply 50 is divided by the first resistor R1 and the second resistor R2 to form a divided voltage V₀ at the node N.

The indicator module 30 includes an indicator 301 and a power supply 302. In the embodiment, the indicator 301 is a light emitting diode (LED) D1. The anode of the LED D1 is connected to the power supply 302, and the cathode of the LED D1 is connected to the path connection module 40. In the embodiment, the anode of the LED D1 is connected to the power supply 302 through a resistor R3.

The path connection module 40 includes a high voltage activated switch 401. In the embodiment, an npn bipolar junction transistor (BJT) Q1 is taken as an example to illustrate the high voltage activated switch. The npn BJT Q1 includes a base, a collector, and an emitter. The base of the npn BJT Q1 is connected to the node N formed between the first resistor R1 and the second resistor R2, the collector of the npn BJT Q1 is connected to the cathode of the LED D1, and the emitter of the npn BJT Q1 is connected to the charger IC 60.

When the connection jack 10 is connected to the power supply 50, the power supply 50 produces a voltage V₀ at the node N, thus the voltage detection module 20 outputs a high level signal to the base of the npn BJT Q1. When the condition of the battery 70 is satisfied, the charger IC 60 outputs a low level signal to the emitter of the npn BJT Q1, causing the base voltage of the npn BJT Q1 to be lower than the emitter voltage of the npn BJT Q1, and the npn BJT Q1 is correspondingly turned on. Thus, the shunt circuit of the indicator module 30 is turned on, resulting in the LED D1 being enabled to be on, to indicate that the battery 70 is being charged.

When the connection jack 10 is not connected to the power supply 50, the voltage detection module 20 outputs a low level signal to the base of the npn BJT Q1. No matter whether the charger IC 60 outputs the low level signal or outputs the high level signal, the base voltage of the npn BJT Q1 is higher than or equal to the emitter voltage of the npn BJT Q1, and the npn BJT Q1 is correspondingly turned off. Thus, the shunt circuit of the indicator module 30 is turned off, resulting in the LED D1 being disabled, to indicate that the battery 70 is not being charged.

When the condition of the battery 70 is not satisfied, the charger IC 60 outputs a high level signal to the emitter of the npn BJT Q1. No matter whether the connection jack 10 is connected to the power supply 50, the base voltage of the npn BJT Q1 is higher than or equal to the emitter voltage of the npn BJT Q1, and the npn BJT Q1 is correspondingly turned off. Thus, the shunt circuit of the indicator module 30 is turned off, resulting in the LED D1 being disabled.

With this configuration, the voltage detection module 20 outputs a high level signal to turn on the path connection module 40 when the connection jack 10 is connected to the power supply 50 and the condition of the battery 70 is satisfied, thus the shunt circuit of the indicator module 30 is enabled, causing the LED D1 to be on. In this way, the charge indicator circuit 1 does not need the controller to control the LED D1 to be on or to be off, to indicate that the battery 70 is not being charged.

Although the current disclosure has been specifically described on the basis of the exemplary embodiment thereof, the disclosure is not to be construed as being limited thereto. Various changes or modifications may be made to the embodiment without departing from the scope and spirit of the disclosure.

## Claims

1. A charge indicator circuit to indicate the state of charge of a battery, the charge indicator circuit comprising:
a connection jack to connect to a power supply to receive power from a power supply;
an indicator module comprising an indicator, the indicator being on when the battery is being charged, and being off when the battery is not charged;
a voltage detection module to output a first response signal when the connection jack is connected to the power supply, and output a second response signal when the connection jack is not connected to the power supply;
a charger IC to manage the charging of the battery, output a low level signal when a condition of the battery is satisfied, and output a high level signal when the condition of the battery is not satisfied; and
a path connection module to be in a shunt circuit of the indicator module,
enable the shunt circuit of the indicator module to cause the indicator to be on when the voltage detection module outputs the first response signal and the charger IC outputs the low level signal, and disable the shunt circuit of the indicator module to cause the indicator to be off when the voltage detection module outputs the second response signal or the charger IC outputs the high level signal.

2. The charge indicator circuit as described in claim 1, wherein the voltage detection module comprises a first resistor and a second resistor, the first resistor and the second resistor are connected in series between the anode of the power supply and ground, the node formed between the first resistor and the second resistor is connected to the path connection module.

3. The charge indicator circuit as described in claim 2, wherein the voltage of the power supply is divided by the first resistor and the second resistor to form a divided voltage at the node formed between the first resistor and the second resistor when the connection jack is connected to the power supply, the voltage detection module outputs a high level signal to the path connection module.

4. The charge indicator circuit as described in claim 2, wherein the voltage detection module outputs a low level signal to the path connection module when the connection jack is not connected to the power supply.

5. The charge indicator circuit as described in claim 1, wherein the path connection module is a high voltage activated switch, the high voltage activated switch is connected to the voltage detection module, the indicator module, and the charger IC.

6. The charge indicator circuit as described in claim 5, wherein the high voltage activated switch is a npn bipolar junction transistor (BJT), the npn BJT comprises a base, a collector, and an emitter, the base of the npn BJT is connected to the voltage detection module, the collector of the npn BJT is connected to the indicator module, and the emitter of the npn BJT is connected to the charger IC.

7. The charge indicator circuit as described in claim 6, wherein the base of the npn BJT is in the high level when the voltage detection module outputs the high level signal to the path connection module, the charger IC output a low level signal to the emitter of the npn BJT, the base voltage of the npn BJT is higher than the emitter voltage of the npn BJT, resulting the npn BJT to be turned on, thus the path connection module enables the shunt circuit of the indicator module.

8. The charge indicator circuit as described in claim 6, wherein the base of the npn BJT is in the low level when the voltage detection module outputs the low level signal to the path connection module, the base voltage of the npn BJT is lower than or equal to the emitter voltage of the npn BJT, resulting the npn BJT to be turned off, thus the path connection module disables the shunt circuit of the indicator module.

9. The charge indicator circuit as described in claim 1, wherein the indicator module comprises an indicator, a resistor, and a power supply, one terminal of the indicator is connected to the power supply through the resistor, and the opposite terminal of the indicator is connected to the path connection module.

10. The charge indicator circuit as described in claim 9, wherein the indicator is on when the path connection module enables the shunt circuit of the indicator module.

11. The charge indicator circuit as described in claim 9, wherein the indicator is off when the path connection module disables the shunt circuit of the indicator module.
